# EUROPÄISCHE PATENTSCHRIFT

(11) **EP 1 709 217 B1**
(45) Veröffentlichungstag und Bekanntmachung des Hinweises auf die Patenterteilung: **18.04.2007**
(21) Anmeldenummer: 04798125.3
(22) Anmeldetag: 30.11.2004
(51) Int. Cl.: C30B 9/00, C30B 9/12, C30B 29/46, C30B 29/60, H01L 31/032

(54) **VERFAHREN ZUR HERSTELLUNG VON CU(IN,GA)SE2-EINKRISTALLINEM PULVER UND DIESES PULVER ENTHALTENDE MONOKORNMEMBRAN-SOLARZELLE**
PROCESS TO PRODUCE A CU(IN,GA)SE2 SINGLE CRYSTAL POWDER AND MONOGRAIN MEMBRANE SOLARCELL COMPRISING THIS POWDER
PROCEDE DE FABRICATION D'UNE POUDRE MONOCRISTALLINE DE CU(IN,GA)SE2 ET CELLULE SOLAIRE AYANT UNE MEMBRANE MONOGRAIN COMPRENANT CETTE POUDRE

(30) Priorität: 22.12.2003 EP 03029576
(43) Veröffentlichungstag der Anmeldung: 11.10.2006
(73) Patentinhaber: Scheuten Glasgroep, 5916 PA Venlo (NL)
(72) Erfinder: GEYER, Volker, 41372 Niederkrüchten (DE); ALTOSAAR, Mare, EE12917 Tallinn (EE); MELLIKOV, Enn, EE75501 Saku (EE); RAUDOJA, Jaan, EE12917 Tallinn (EE)
(74) Vertreter: Jostarndt, Hans-Dieter
(86) Internationale Anmeldenummer: PCT/EP2004/013568
(87) Internationale Veröffentlichungsnummer: WO 2005/064046

(56) Entgegenhaltungen:
- EP-A- 0 828 299
- US-B1- 6 488 770
- ALTOSAAR M ET AL: "Monograin layer solar cells" PREPARATION AND CHARACTERIZATION, ELSEVIER SEQUOIA, NL, Bd. 431-432, 1. Mai 2003 (2003-05-01), Seiten 466-469, XP004428688 ISSN: 0040-6090

## Beschreibung

Die Erfindung betrifft ein Verfahren zur Herstellung von einkristallinem Pulver, das aus einer Cu(In,Ga)Se₂-Verbindung besteht. Die Erfindung betrifft zudem eine Verwendung des mit dem Verfahren hergestellten Pulvers.

Derartige Pulver eignen sich dabei besonders zur Herstellung von Monokornmembranen, die in Solarzellen eingesetzt werden.

Aus der internationalen Patentanmeldung WO 99/67449 ist ein gattungsgemäßes Verfahren zur Herstellung von einkristallinem, aus einem Halbleitermaterial bestehenden Pulver bekannt, mit dem Pulverkörner aus CuInSe₂ hergestellt werden können. Bei diesem Verfahren werden die Komponenten des Halbleitermaterials in stöchiometrischer Zusammensetzung aufgeschmolzen, ein Flussmittel wird zugegeben, und die Schmelze mit dem Flussmittel wird auf eine Temperatur gebracht, bei der das Pulver auskristallisiert und die Pulverkörner heranwachsen. Als Flussmittel können NaCl, Se, As, Arsenide oder Selenide eingesetzt werden.

Der Erfindung liegt die Aufgabe zugrunde, ein gattungsgemäßes Verfahren so weiterzuentwickeln, dass die Eigenschaften der Pulverkörner im Hinblick auf einen Einsatz in einer Solarzelle verbessert werden.

Es ist ferner Aufgabe der Erfindung, eine Monokornmembran-Solarzelle zu schaffen, die einen möglichst hohen Wirkungsgrad aufweist.

Bezüglich des Verfahrens wird diese Aufgabe erfindungsgemäß durch ein Verfahren zur Herstellung eines aus einer Cu(In,Ga)Se₂-Verbindung bestehenden Pulvers gelöst, das folgende Schritte beinhaltet:
- Legieren von Cu und In und/oder von Cu und Ga zu einer CuIn- und/oder CuGa-Legierung mit einem unterstöchiometrischen Anteil an Cu,
- herstellen eines aus der CuIn- und/oder CuGa-Legierung bestehenden Pulvers,
- zugeben von Se sowie entweder KI oder NaI zu dem Pulver,
- aufheizen des Gemischs, bis eine Schmelze entsteht, in der die Cu(In,Ga)Se₂-Verbindung rekristallisiert und es gleichzeitig zum Wachstum der herzustellenden Pulverkörner kommt,
- abkühlen der Schmelze, um das Wachstum der Körner zu unterbrechen.

Bei dem erfindungsgemäßen Verfahren ergibt sich die überraschende Wirkung, dass die mit diesem Verfahren hergestellten Körner erheblich verbesserte photovoltaische Eigenschaften aufweisen als die mit dem bekannten Verfahren gemäß dem Stand der Technik produzierten.

Solarzellen, in denen das anhand des erfindungsgemäßen Verfahrens erzeugte Pulver eingesetzt wurde, erreichten einen erheblich gesteigerten Wirkungsgrad.

Dies könnte die folgenden Ursachen haben:

Bei dem bekannten Verfahren gemäß dem Stande der Technik könnte aufgrund des Einsatzes einer bezüglich der herzustellenden CuInSe₂-Verbindung stöchiometrischen Menge an Cu das Problem auftreten, dass sich Cu-reiche Pulverkörner bilden. In diesen Körnern kann eine Phasensegregation in stöchiometrisches CuInSe₂ und eine metallische CuSe-Binärphase stattfinden, wobei sich diese Fremdphase bevorzugt an der Oberfläche der Körner ansammelt und die Eigenschaften einer Solarzelle erheblich verschlechtert. So kann es etwa zu einem Kurzschluss im pn-Kontakt der Zelle kommen.

Ferner kommt es bei dem bekannten Verfahren wohl zu einer Ablagerung von während der Herstellung entstehenden CuSe-Phasen an den Körnern. Es ist bekannt, dass diese Phasen mit Hilfe einer KCN-Lösung ausgewaschen werden können; diese greift jedoch auch die Körner selbst an.

Es wird vermutet, dass demgegenüber der Einsatz einer bezüglich der herzustellenden Verbindung unterstöchiometrischen Menge an Cu bei dem erfindungsgemäßen Verfahren dazu führt, dass die Bildung von Cureichen Körnern weitgehend unterdrückt wird und sich hauptsächlich Cu-arme Pulverkörner bilden, die zur Fertigung von hocheffizienten Solarzellen geeignet sind.

Ferner wird angenommen, dass die bei der Herstellung der Körner entstehenden binären CuSe-Phasen in den erfindungsgemäß eingesetzten Flussmitteln KI und NaI verbleiben und sich nicht an den Körnern ablagern.

Dies scheint insbesondere dann der Fall zu sein, wenn die Schmelze sehr schnell, also in Form eines Abschreckens ("Quenchens") abgekühlt wird.
Ein weiterer Vorteil des erfindungsgemäßen Verfahrens besteht darin, das Flussmittel mit Wasser auslösen zu können, welches die Körner selbst nicht angreift.

In einer bevorzugten Durchführungsform des erfindungsgemäßen Verfahrens wird das KI oder NaI daher nach dem Abkühlen durch ein Auslösen mit Wasser aus der abgekühlten Schmelze entfernt.

Es ist weiterhin sehr vorteilhaft, dass ein Verhältnis der eingesetzten Molmenge an Cu zu der Summe der eingesetzten Molmenge an In und der eingesetzten Molmenge an Ga zwischen 0,8 und 1 liegt.

Es hat sich gezeigt, dass mit Pulverkörnern, die dieses Verhältnis der Molmenge an Cu zu der Molmenge an In und Ga aufweisen, Solarzellen hergestellt werden können, die einen besonders hohen Wirkungsgrad erreichen.

Es ist zudem vorgesehen, dass ein Verhältnis der eingesetzten Molmenge an Ga zu der eingesetzten Molmenge an In zwischen 0 und 0,43 liegt. Ein Verhältnis von 0,43 entspricht dabei etwa einem Ga-Anteil von 30% bezogen auf die Molmenge an In und Ga.

Die Bandlückenenergie der Cu(In,Ga)Se₂-Halbleiterverbindung variiert mit dem Verhältnis der eingesetzten Menge an In zu der eingesetzten Menge an Ga, und anhand der möglichen Werte dieses In/Ga-Verhältnisses kann die Bandlückenenergie des Halbleitermaterials dem gewünschten Anwendungszweck gut angepasst werden.

Ferner wird im Rahmen der Erfindung eine vorteilhafte Solarzelle geschaffen.

Insbesondere handelt es sich dabei um eine Monokornmembran-Solarzelle, bestehend aus einem Rückkontakt, einer Monokornmembran, mindestens einer Halbleiterschicht und einem Frontkontakt, die sich dadurch auszeichnet, dass die Monokornmembran das erfindungsgemäß hergestellte Pulver enthält.

Einige bevorzugte Durchführungsformen des Verfahrens und bevorzugte Ausführungsformen der Solarzelle Pulvers werden nun im Folgenden detailliert dargestellt:

Zunächst werden Cu und In und/oder Cu und Ga legiert, wobei die eingesetzten Molmengen an Cu einerseits und In und Ga andererseits so bemessen werden, dass Cu-arme CuIn und CuGa-Legierungen entstehen. Es hat sich dabei als besonders vorteilhaft für die Herstellung von in Solarzellen eingesetzten Pulverkörnern ergeben, dass das Cu/(In+Ga)-Verhältnis, also das Verhältnis der eingesetzten Molmenge an Cu zu der Summe der eingesetzten Molmenge an In und der eingesetzten Molmenge an Ga, zwischen 1 und 1:1,2 liegt.

Das Verhältnis der eingesetzten Molmenge an Ga zu der eingesetzten Molmenge an In liegt vorzugsweise zwischen 0 und 0,43. Ein Verhältnis von 0,43 entspricht dabei etwa einem Ga-Anteil von 30% bezogen auf die Molmenge an In und Ga. Es werden mit dem erfindungsgemäßen Verfahren also vorzugsweise solche Cu(In,Ga)Se₂-Verbindungen hergestellt, die in ihrem Molverhältnis zwischen Ga und In zwischen diesem Molverhältnis der Verbindungen CuInSe₂ und CuGa_{0,3}In_{0,7}Se₂ liegen.

Die Legierungen werden dann zu einem Pulver zermahlen, wobei sich herausgestellt hat, dass die Korngrößen der herzustellenden Cu (In,Ga)Se₂-Pulverkörner von den Korngrößen des aus der CuIn- und/oder CuGa-Legierung hergestellten Pulvers abhängen. Es werden also gezielt Pulver mit einer bestimmten Größe der enthaltenen Körner gemahlen.

Das aus den Legierungen CuIn und CuGa bestehende Pulver wird nun in eine Ampulle gefüllt, die aus einem Material besteht, das mit keinem der hineinzugebenden Stoffe reagiert. Es besteht somit beispielsweise aus Quarzglas.

Zu dem Pulver wird Se in einer Menge hinzugegeben, die dem stöchiometrischen Anteil dieses Elementes an der herzustellenden Cu(In,Ga)Se₂-Verbindung entspricht.

Ferner wird entweder KI oder NaI als Flussmittel hinzugegeben, wobei der Anteil des Flussmittels an der später entstehenden Schmelze typischerweise etwa 40 Vol.-% beträgt. Im Allgemeinen kann der Anteil des Flussmittels an der Schmelze jedoch zwischen 10 und 90 Vol.-% liegen.

Die Ampulle wird nun evakuiert und mit dem angegebenen Inhalt auf eine Temperatur zwischen 650°C und 810°C erwärmt. Während des Erwärmens bildet sich Cu(In,Ga)Se₂.

Ist eine Temperatur innerhalb des genannten Temperaturbereichs erreicht, kommt es zur Rekristallisation von Cu(In,Ga)Se₂ und gleichzeitig zu Kornwachstum.

Das Flussmittel ist bei dieser Temperatur geschmolzen, so dass der Raum zwischen den Körnern mit einer flüssigen Phase gefüllt ist, die als Transportmedium dient.

Die Schmelze wird während einer gewissen Haltezeit konstant auf der vorher eingestellten Temperatur gehalten. Je nach gewünschter Korngröße kann eine Haltezeit zwischen 5 Minuten und 100 Stunden erforderlich sein. Typischerweise beträgt sie etwa 30 Stunden.

Das Kornwachstum wird durch ein Abkühlen der Schmelze unterbrochen. Es ist dabei sehr vorteilhaft, die Schmelze sehr schnell, beispielsweise innerhalb weniger Sekunden, abzuschrecken.

Dieses so genannte "Quenchen" scheint notwendig zu sein, damit evtl. entstandene binäre CuSe-Phasen im Flussmittel verbleiben.

Bei einem langsamen Abkühlen besteht vermutlich die Gefahr, dass sich die CuSe-Phasen auf den Cu(In,Ga)Se₂-Kristallen ablagern und die Eigenschaften des hergestellten Pulvers im Hinblick auf einen Einsatz in Solarzellen erheblich beeinträchtigen.

In einem letzten Schritt des Verfahrens wird das Flussmittel durch ein Auslösen mit Wasser entfernt. Die einkristallinen Pulverkörner können der Ampulle dann entnommen werden.

Der geeignete zeitliche Temperaturverlauf beim Erwärmen und Abkühlen sowie die Haltezeit und die während der Haltezeit einzuhaltende Temperatur werden in Vorversuchen ermittelt.

Mit Hilfe des dargestellten Verfahrens lassen sich Pulver mit einem mittleren Durchmesser der einzelnen Körner von 0,1 µm bis 0,1 mm herstellen. Die Korngrößenverteilung innerhalb des Pulvers entspricht dabei einer Gauß-Verteilung der Form D=A·t^{1/n}·exp(-E/kT), wobei D der Korndurchmesser, t die Haltezeit und T die Temperatur der Schmelze ist; k bezeichnet wie üblich die Boltzmann-Konstante. Die Parameter A, n und E hängen von den eingesetzten Ausgangsstoffen, dem Flussmittel und den speziellen und hier nicht näher beschriebenen Wachstumsprozessen ab. Wird KI als Flussmittel eingesetzt, so ist etwa E = 0,25 eV. Der Wert für n liegt in diesem Falle zwischen 3 und 4.

Die mittlere Korngröße und die genaue Gestalt der Korngrößenverteilung hängen von der Haltezeit, der Temperatur der Schmelze und der Korngröße des eingesetzten aus den CuIn- und CuGa-Legierungen bestehenden Pulvers ab. Darüber hinaus werden mittlere Korngröße und Korngrößenverteilung von der Wahl des Flussmittels beeinflusst.

Die mit dem erfindungsgemäßen Verfahren herstellbaren Körner sind p-leitend und weisen eine sehr gute elektrische Leitfähigkeit auf. Die elektrischen Widerstände der hergestellten Cu(In,Ga)Se₂-Pulverkörner lagen je nach Wahl des Cu/Ga-Verhältnisses, des Cu/(In+Ga)-Verhältnisses und der Temperatur der Schmelze in einem Bereich von 100 Ω bis 10 kΩ. Dies entspricht einem spezifischen Widerstand von 10 kΩcm bis 2 MΩcm.

Mit Hilfe des erfindungsgemäßen Verfahrens konnten einkristalline Pulver produziert werden, deren Körner eine sehr gleichmäßige Zusammensetzung aufwiesen.

Die Pulver eignen sich besonders zur Herstellung von Monokornmembranen, die in Solarzellen Verwendung finden, wobei mit den anhand des erfindungsgemäßen Verfahrens hergestellten Pulvern Solarzellen mit einem sehr hohen Wirkungsgrad produziert werden konnten.

Vor allem im Hinblick auf mögliche Einsatzzwecke des mit dem erfindungsgemäßen Verfahren hergestellten Pulvers wird zudem darauf hingewiesen, dass es prinzipiell auch möglich ist, S zusätzlich zum Se zu dem aus den CuIn und/oder CuGa bestehenden Pulver hinzuzugeben und mit dem Flussmittel aufzuschmelzen. Ebenso kann Se vollständig durch S ersetzt werden.

Das Verfahren ermöglicht damit die Herstellung einer großen Bandbreite von CuIn₁₋ₓGaₓS_{y}Se_{z}-Verbindungen. Diese Halbleiterverbindungen decken einen Bereich von Bandlückenenergien zwischen 1,04 eV und 2,5 eV ab.

Es hat sich gezeigt, dass die mit dem dargestellten Verfahren hergestellten Pulver sehr vorteilhaft in Solarzellen eingesetzt werden können. Die Solarzellen in denen diese Pulver verwendet wurden zeigten einen überdurchschnittlich hohen Wirkungsgrad.

Bei den Solarzellen in denen erfindungsgemäß hergestellte Pulver eingesetzt werden handelt es sich dabei vorzugsweise um Solarzellen in die eine mit dem Pulver hergestellte Monokornmembran eingebracht wird.

Zur Herstellung der Monokornmembran werden die Pulverkörner dabei vorzugsweise in eine Polymermembran, beispielsweise eine Polyurethan-Matrix, eingebettet.

Eine Monokornmembran- Solarzelle besteht üblicherweise aus 4 Schichten.

Als Rückkontakt dient eine metallische Schicht, die typischerweise auf ein Glassubstrat aufgebracht wird. In einer bevorzugten Ausführungsform kann es sich dabei auch um einen elektrisch leitfähigen Klebstoff handeln.

Auf diesen Rückkontakt wird die, die Cu(In,Ga)Se₂-Kristalle enthaltende, Membran als Absorberschicht aufgebracht, die üblicherweise mit einer dünnen, n-leitenden CdS- Halbleiterschicht bedeckt wird.

Auf diese CdS-Schicht ist dann der Frontkontakt aufgebracht, der üblicherweise aus einem transparenten, elektrisch leitenden Oxid, beispielsweise einer ZnO:Al-Legierung, besteht.

Es kann ebenfalls sehr bevorzugt sein, zwischen die CdS-Schicht und den Frontkontakt eine weitere aus intrinsischem ZnO bestehende Halbleiterschicht einzubringen.

## Patentansprüche

1. Verfahren zur Herstellung eines aus einer Cu(In,Ga)Se₂-Verbindung bestehenden Pulvers,
**dadurch gekennzeichnet,**
**dass** es folgende Schritte beinhaltet:
- Legieren von Cu und In und/oder von Cu und Ga zu einer CuIn- und/oder CuGa-Legierung mit einem unterstöchiometrischen Anteil an Cu,
- herstellen eines aus der CuIn- und/oder CuGa-Legierung bestehenden Pulvers,
- zugeben von Se sowie entweder KI oder NaI zu dem Pulver,
- aufheizen des Gemischs, bis eine Schmelze entsteht, in der Cu(In,Ga)Se₂-Verbindung rekristallisiert und es gleichzeitig zum Wachstum der herzustellenden Pulverkörner kommt,
- abkühlen der Schmelze, um das Wachstum der Körner zu unterbrechen.

2. Verfahren nach Anspruch 1,
**dadurch gekennzeichnet,**
**dass** das KI oder NaI nach dem Abkühlen durch ein Auslösen mit Wasser entfernt wird.

3. Verfahren nach einem oder beiden der Ansprüche 1 und 2,
**dadurch gekennzeichnet,**
**dass** ein Verhältnis der eingesetzten Molmenge an Cu zu der Summe der eingesetzten Molmenge an In und der eingesetzten Molmenge an Ga zwischen 0,8 und 1 liegt.

4. Verfahren nach einem oder mehreren der vorangegangenen Ansprüche,
**dadurch gekennzeichnet,**
**dass** ein Verhältnis der eingesetzten Molmenge an Ga zu der eingesetzten Molmenge an In zwischen 0 und 0.43 liegt.

5. Monokornmembran-Solarzelle, beinhaltend einen Rückkontakt, eine Monokornmembran, mindestens eine Halbleiterschicht und einen Frontkontakt,
**dadurch gekennzeichnet,**
**dass** die Monokornmembran ein mit einem Verfahren nach einem oder mehreren der Ansprüche 1 bis 4 hergestelltes Pulver enthält.

## Claims

1. A method for the production of a powder consisting of a Cu(In,Ga)Se₂ compound,
**characterized in that**
it comprises the following steps:
- alloying Cu and In and/or Cu and Ga to form a CuIn and/or CuGa alloy with a sub-stoichiometric fraction of Cu,
- producing a powder consisting of the CuIn and/or CuGa alloy,
- adding Se as well as either KI or NaI to the powder,
- heating up the mixture until a melt is formed in which the Cu(In,Ga)Se₂ recrystallizes and, at the same time, the powder particles to be produced grow,
- cooling off the melt in order to interrupt the growth of the particles.

2. The method according to Claim 1,
**characterized in that**,
after cooling off, the KI or NaI is removed by means of dissolution with water.

3. The method according to one or both of Claims 1 or 2,
**characterized in that**
the ratio of the molar amount of Cu employed to the sum of the molar amount of In employed plus the molar amount of Ga employed lies between 0.8 and 1.

4. The method according to one or more of the preceding claims,
**characterized in that**
the ratio of the molar amount of Ga employed to the molar amount of In employed lies between 0 and 0.43.

5. A mono-particle membrane solar cell, comprising a back contact, a mono-particle membrane, at least one semiconductor layer and a front contact,
**characterized in that**
the mono-particle membrane contains a powder produced by a method according to one or more of Claims 1 to 4.

## Revendications

1. Procédé pour la production d'une poudre se composant d'une combinaison de Cu(In,Ga)Se₂
**caractérisé en ce que**
il contient des démarches suivantes:
- opération d'allier du Cu et du In et/ ou du Cu et du Ga à un alliage de Culn et/ou de CuGa avec une partie sous- stoechiométrique de Cu,
- production d'une poudre se composant de l'alliage de Culn et/ ou de CuGa,
- adjonction de Se autant que soit de KI, soit de NaI à la poudre,
- échauffement du mélange jusqu'à-ce qu'il se forme une fonderie dans laquelle l'alliage de Cu(In,Ga)Se₂ recristallise et il se passe une croissance des grenailles de poudre en même temps,
- refroidissement de la fonderie pour interrompre la croissance des grenailles.

2. Procédé selon la revendication 1,
**caractérisé en ce que**
le KI ou le NaI est enlevé après le refroidissement par un déclenchement avec de l'eau.

3. Procédé selon une ou deux des revendications 1 et 2,
**caractérisé en ce que**
un rapport de la quantité de mole placée de Cu à la somme de la quantité de mole placée de In et la quantité de mole placée de Ga se trouve entre 0,8 et 1.

4. Procédé selon une ou plusieurs des revendications précédentes,
**caractérisé en ce que**
un rapport de la quantité de mole placée de Ga à la quantité de mole placée de In se trouve entre 0 et 0,43.

5. Cellule solaire de membrane mono-grenaille, comportant un contact de retour, une membrane mono grenaille, au moins une couche du semi- conducteur et un contact frontal,
**caractérisé en ce que**
la membrane mono grenaille contient une poudre produite avec un procédé selon une ou plusieurs des revendications 1 à 4.
